# EUROPÄISCHE PATENTANMELDUNG

(11) **EP 0 805 355 A2**
(43) Veröffentlichungstag der Anmeldung: **05.11.1997**
(21) Anmeldenummer: 97106758.2
(22) Anmeldetag: 24.04.1997
(51) Int. Cl.: G01R 31/08

(54) **Verfahren und Vorrichtung zur Bestimmung des Abstandes eines Kabelfehlers**

(30) Priorität: 30.04.1996 DE 19617243
(71) Anmelder: Dipl.-Ing. H. Horstmann GmbH, 42579 Heiligenhaus (DE)
(72) Erfinder: Böttcher, Helmut, Dipl.-Phys., 42549 Velbert (DE); Krumme, Holger, Dipl.-Ing., 42579 Heiligenhaus (DE)
(74) Vertreter: Götz, Friedrich, Dipl.-Phys.

(57) **Zusammenfassung**

Gegenstand der Erfindung ist ein Verfahren und eine Vorrichtung zur Messung des Abstandes eines Kabelfehlers von einer Schalt- oder Meßstation in einem Mittelspannungsnetz.
Bei Nachrichtenkabeln ist es bekannt, in das spannungslose System Impulse einzuspeisen, die von einer Fehlerstelle reflektiert werden. Aus den Laufzeiten soll die Fehlerentfernung errechnet werden.

Aufgabe der Erfindung ist es, ein einfaches Meßverfahren zur Kurzschlußortung in Energiekabeln zu schaffen, das Fehlereinflüsse ausschaltet.
Gelöst wird diese Aufgabe dadurch, daß die Laufzeiten der vom Lichtbogen erzeugten elektrischen und/oder akustischen Signale im Kabel in den Kabelabschnitten beiderseits vom Lichtbogen gemessen und daraus die Abstände der Fehlerstelle zu den Enden des Kabelabschnittes berechnet werden.

## Beschreibung

### Technisches Gebiet

Die Erfindung betrifft ein Verfahren und eine Vorrichtung zur Bestimmung des Abstandes eines Kabelfehlers von einer Schalt- oder Meßstation in einem zwischen zwei Schaltstationen verlegten Mittelspannungskabel.

### Stand der Technik

Aus der Praxis der Fehlerortung in Nachrichtenkabeln sind Geräte bekannt geworden, die vor Ort an ein abgeschaltetes Kabel angeschlossen werden und dann elektrische Impulse aussenden, die von einer Fehlerstelle reflektiert werden. Ein Mikroprozessor erfaßt den Sendeimpuls und den Rücklaufimpuls, ermittelt die Laufzeit und berechnet daraus die Entfernung des Fehlers.
Das Gerät ist mit einem Bildschirm ausgestattet, auf dem die Impulsverläufe in Abhängigkeit von der Zeit angezeigt werden. Wenn man mit Hilfe eines Tastenfeldes einen Cursor auf dem Display verschiebt, bis eine Marke den Fehlerpunkt erreicht hat, zeigt ein Zählwerk die Fehlerentfernung an.
Die allgemein bekannten Verfahren der Impulsreflektometrie zur Ortung von Kabelfehlem leiden darunter, daß die Impulslaufzeit stark von der Impedanz des Kabels abhängig ist und daß diese Impedanz an einem defekten Kabel nicht exakt meßbar ist.
Es gibt viele Vorschläge, aus den gemessenen elektrischen Werten die Impedanz zu bestimmen, um den Meßfehler zu verringern. So ist es bekannt, aus den vor dem Fehler gemessenen Werten von Strom und Spannung die Kabelimpedanz zu bestimmen.
Einen weiteren großen Einfluß auf die Meßgenauigkeit hat die Impedanz der Fehlerstelle.
Nur wenn sich die Impedanz der Fehlerstelle deutlich von der Impedanz des Kabels unterscheidet, sind eindeutige Reflexionen der ausgesendeten Impulse an der Fehlerstelle zu erhalten. Beispielsweise wird an einer permanenten Verbindung mit einem sehr geringen Widerstand durch eine verkohlte Isolation oder durch geschmolzenes Metall eines Leiters der Impuls mit invertierter Polarität reflektiert. An einer Fehlerstelle mit einer Unterbrechung des Stromleiters wird der Impuls mit gleicher Polarität reflektiert. Wenn aber nur die Isolation teilweise zerstört ist, entsteht für die Meßimpulse eine Impedanzdiskontinuität mit einem sehr geringen Reflexionsanteil. Dieser häufig auftretende Fall eines Kabelfehlers erfordert einen hohen apparativen Aufwand zur Auswertung der Signale durch speziell ausgebildete Fachkräfte.
Ein anderes Verfahren ist vorgeschlagen worden, bei dem die Meßimpulse in das defekte Kabel eingespeist werden, bevor die Kabelüberwachungseinrichtung das defekte Kabel abgeschaltet hat. Dabei werden die ausgesendeten Meßimpulse gleichfalls an der Fehlerstelle am Lichtbogen reflektiert. Hierbei kann aber vorausgesetzt werden, daß der Lichtbogenwiderstand klein gegen die Kabelimpedanz ist, wodurch der Betrag des Reflexionsfaktors nahe 1 liegt. Weiterhin werden vom Lichtbogen aber gleichzeitig Störsignale erzeugt, die im gleichen Amplituden- und Frequenzbereich wie die eingekoppelten Meßimpulse liegen.
Durch ein aufwendiges Verfahren mit schneller Fouriertransformation und Korrelationsrechnung gelingt es, aus dem Signalgemisch die reflektierten Impulse mit hoher Genauigkeit auszufiltern und die Laufzeit der Impulse im Kabel exakt zu bestimmen.
Zur weiteren Verringerung des Meßfehlers werden in regelmäßigen Zeitabständen im normalen Betriebszustand in das Kabel Testimpulse eingekoppelt, aus deren Laufzeit Referenzwerte für die aktuelle Impedanz des gesamten Kabels gewonnen werden.
Relativ aufwendig an diesem Verfahren ist die Notwendigkeit eines fest installierten Impulsgenerators für die Hochspannungsimpulse und die feste Verbindung des Impulsgenerators mit dem Kabel über einen Hochspannungskondensator. Diese feste Verbindung des Hochspannungskondensators mit dem Kabel erfordert einen beträchtlichen zusätzlichen Installationsaufwand und muß allen Sicherheitsanforderungen genügen. Daher ist dieses Verfahren in engen kompakten Schaltanlagen nicht immer durchführbar.

### Darstellung der Erfindung

Die Erfindung hat die Aufgabe, mit einer einfach zu installierenden Anordnung und mit einem geringen apparativen Aufwand in Energieversorgungsanlagen mit einem ausgedehnten Kabelnetz eine Fehlerortung mit hoher Genauigkeit zu ermöglichen.
Diese Aufgabe wird dadurch gelöst, daß die Laufzeiten der vom Lichtbogen erzeugten elektrischen und/oder akustischen Signale im Kabel in den Kabelabschnitten beiderseits vom Lichtbogen gemessen und daraus die Abstände der Fehlerstelle zu den Enden des Kabelabschnittes berechnet werden.
Anstatt Impulse in das Kabel einzuspeisen, werden also die vom Lichtbogen selbst erzeugten Signale ausgenutzt. Es handelt sich dabei sowohl um elektrische Impulse als auch um Körperschallsignale mit einem rein zufälligen Signalverlauf. Die Signale werden grundsätzlich an den Kabelenden, die elektrischen Signale außerdem am Lichtbogen selbst reflektiert. Der Verlauf der vom Lichtbogen erzeugten Signale wird mit einem Sensor gemessen und nach der Umformung mit einem schnellen Analog-Digital-Wandler als digitales Signal in einem Speicher abgelegt. Durch Filterung mit einer 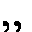 Fast Fourier Transformation" und einer Korrelationsanalyse ist es möglich, den exakten Zeitpunkt des Eintreffens des vom Lichtbogen direkt in Richtung Sensor ausgesendeten Signals und die Zeitpunkte des Eintreffens der an den Kabelenden und am Lichtbogen reflektierten Signale zu bestimmen.
Aus diesem verzögerten Eintreffen der reflektierten Signalanteile gegenüber dem direkten Signal sind die Impulslaufzeiten der Signale auf den Kabelabschnitten vor und hinter dem Lichtbogen bestimmbar. Da die Kabellänge zwischen zwei Stationen bekannt ist, kann damit der exakte Fehlerort bestimmt werden.
Zur Erhöhung der Genauigkeit werden nicht nur die Impulsflanken im Moment des Isolationsdurchbruches bestimmt, sondern auch die Flanken bei jedem Wiederzünden des Lichtbogens und beim Abschalten. Die gemessenen Laufzeiten werden gemittelt. Als Basis für die Laufzeitenermittlung kann sowohl die Kabelspannung als auch der Kabelstrom dienen.
Zur Weiterverarbeitung der Daten wird vorzugsweise eine Mikroprozessoreinheit eingesetzte die mit einer Signalaufzeichnungseinheit gekoppelt ist.
Das Ergebnis wird dann einer Anzeigeeinheit zugeführt.

In einer anderen Ausführungsform der Erfindung werden die gemessenen Signale so lange in einem Zwischenspeicher abgelegt, bis die durch das Fehlersignal angeregte Datenleitung zu einem Rechner steht. Die Daten werden dann sofort übertragen und mit hoher Rechenkapazität exakt ausgewertet.
Diese Ausführungsform hat den Vorteil, daß nicht an jedem Meßpunkt ein nur ganz selten benötigter Rechner installiert und betriebsbereit gehalten werden muß.
Die Verwendung eines zentralen Rechners ist auch insofern günstig, als die Software zwecks Programmverbesserung leichter aktualisiert werden kann.

In einer weiteren Ausgestaltung der Erfindung fungieren die Sensoren an den einzelnen Meßpunkten lediglich als Datensammler ohne Anschluß an ein Datennetz. Falls ein Kabelfehler auftritt, werden die infragekommenden Meßpunkte mit Hilfe einer mobilen Recheneinheit, beispielsweise einem Laptop, abgefragt. Nach Auswertung der Daten kann dann ein Serviceteam gezielt zum Einsatzort gebracht werden.

Die Anwendung der Erfindung ist nicht auf solche Kabelnetze beschränkt, deren Stationen bereits mit Sensoren und Zusatzeinrichtungen ausgestattet sind.
Es ist auch möglich, die neuartige Vorrichtung zur Lokalisierung eines Kabelfehlers erst nach dem Eintritt des Fehlers und der Abschaltung eines Kabelstranges zu installieren.
Nach Aktivierung der Meßeinrichtung wird dann ganz gezielt eine Spannung aufgeschaltet, um an der zu ortenden Fehlerstelle erneut einen Kurzschlußlichtbogen zu zünden.

### Beschreibung der Zeichnungen

Ausführungsbeispiele der Erfindung werden anhand von Fig. 1 - 5 der Zeichnung erläutert.
Fig. 1 zeigt einen Netzabschnitt mit Schaltstationen und Meßeinrichtung,
Fig. 2 ein Impulsdiagramm,
Fig. 3 ein Blockschaltbild der Meßeinrichtungen,
Fig. 4 ein weiteres Beispiel eines Netzabschnittes mit Meßeinrichtungen,
Fig. 5 das Blockschaltbild einer Ortungseinrichtung in einer Schaltstation.

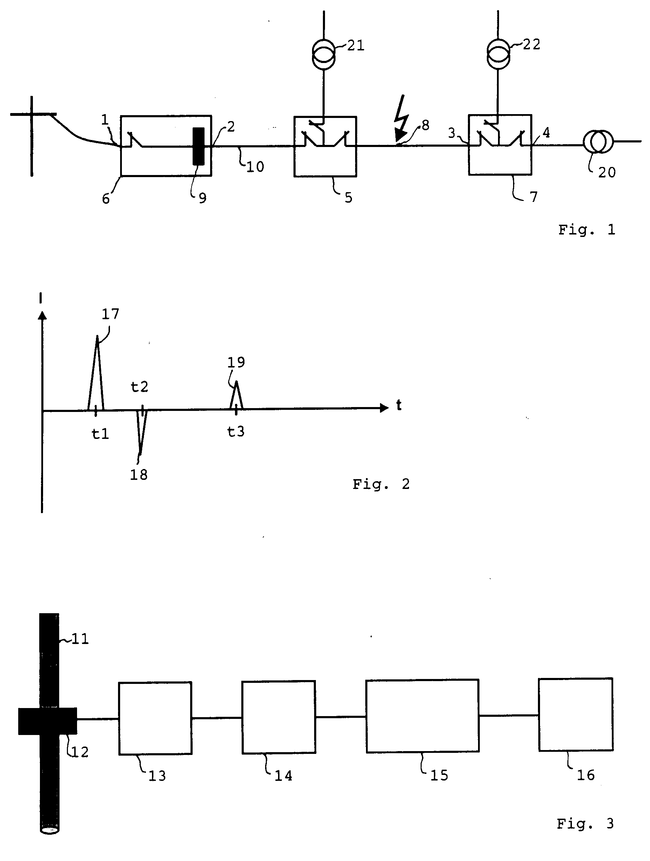

In Fig. 1 ist mit 1 der Einspeisepunkt bezeichnet, mit 2 der Anfang des zu überwachenden Kabelabschnittes, mit 3 dessen Ende. Ein Transformator 20 ist an einem Punkt 4 angeschlossen. Weitere Transformatoren 21 und 22 sind an die Schaltstationen 5 und 7 angeschlossen. In einer Schaltstation 6 am Anfang des Kabels ist ein Meßgerät 9 zur Fehlerortung untergebracht. Dieses Gerät soll das Kabel 10 zwischen dem Anfangspunkt 2 und dem Endpunkt 3 überwachen. Ein Blitzpfeil soll den Ort 8 eines möglichen Fehlers kennzeichnen. Im Falle eines Kurzschlusses an diesem Punkt entsteht ein Lichtbogen, der elektrische Impulse erzeugt. Diese Impulse bewegen sich auf dem Kabel mit einer durch die Kabelimpedanz fest vorgegebenen Ausbreitungsgeschwindigkeit in beiden Richtungen vom Lichtbogen weg. Der in Richtung zur Station 6 wandernde Impuls durchläuft die Schaltstation 5 und erreicht am Punkt 2 als erster die Meßeinrichtung 9.
Der in Richtung der Schaltstation 7 laufende Impuls wird am Punkt 3 reflektiert. Er läuft auf dem Kabel 10 zurück in Richtung auf die Schaltstation 6 und erreicht als zweiter Impuls die Meßeinrichtung 9. Aus der Laufzeitdifferenz kann die Entfernung des Fehlerortes 8 ermittelt werden.
Reflexionen der Impulse treten mehrfach auf. So wird der erwähnte 1. Impuls am Punkt 2 reflektiert, läuft zurück bis zum Fehlerort 8, wird dort erneut reflektiert und erreicht wiederum die Meßeinrichtung 9.

Die Impulsfolgen sind in Fig. 2 in einem Strom-Zeit-Diagramm dargestellt. Bei einem Kurzschluß zum Zeitpunkt t = 0 erreicht der in Richtung Meßeinrichtung 9 laufende 1.
Impuls 17 den Sensor zur Zeit t1. Der 2. Impuls 18 läuft vom Fehlerort 8 zum Endpunkt 3, wird dort invertierend reflektiert und erreicht zum Zeitpunkt t2 die Meßeinrichtung 9.
Der 1. Impuls 17, der am Anfangspunkt 2 gemessen und zugleich reflektiert wurde, erfährt eine zweite Reflexion am Fehlerort 8 und taucht dann zum Zeitpunkt t3 als abgeschwächter Impuls 19 in der Meßeinrichtung 9 auf.
Aus den absoluten Impulslaufzeiten und den Größenverhältnissen der Zeiten t1, t2 und t3 kann die Fehlerentfernung und - da die Gesamtlänge des überwachten Kabels bekannt ist - auch die Ausbreitungsgeschwindigkeit im Impulse bestimmt werden.
Es muß ausdrücklich darauf hingewiesen werden, daß die dargestellten Impulse 17, 18, 19 stark idealisiert sind. Die vom Lichtbogen erzeugten Signale bestehen aus einem Gemisch sehr vieler stochastischer Impulse in einem sehr breiten Frequenzband. Es ist daher eine Aufgabe von besonderem Schwierigkeitsgrad, aus diesem Impulsgemisch den exakten Zeitpunkt des Eintreffens der genannten Impulsflanken herauszufinden. Dies gilt um so mehr, als ja weitere störende Reflexionen in der Schaltstation 5 oder anderen Anlagenteilen stattfinden können.

Um die Signale richtig deuten und auswerten zu können, ist eine Einrichtung erforderlich, wie sie im Blockschaltbild nach Fig. 3 dargestellt ist.
Auf dem überwachten Kabel 11 sitzt ein Stromsensor 12, der den Kabelstrom ständig überwacht. Sein Signal wird in einem Analog-Digital-Wandler umgesetzt und in einem Speicher 14 abgelegt. Ein Mikroprozessor 15 überwacht ständig die Größe des Stromsignals. Unmittelbar nach einem Kurzschluß stoppt der Rechner die Signalaufzeichnung im Speicher 14, wobei eine gewisse Nachlaufzeit berücksichtigt wird.
Somit stehen jetzt Daten zur Verfügung, die den Signalverlauf kurz vor dem Fehlereintritt und einige Zeit danach umfaßt. Der Mikroprozessor 15 führt nun mit diesem Datensatz Berechnungen durch, deren Ergebnis dann die in Fig. 2 dargestellten Impulslaufzeiten sind.
Unter dem Begriff 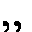 Berechnungen" ist hier eine digitale Signalfilterung, eine schnelle Fouriertransformation und eine Korrelationsrechnung zu verstehen.
Aus den Zeitdifferenzen zwischen den Laufzeiten t1, t2 und t3 und der bekannten Kabellänge kann der Abstand zwischen dem Anfangspunkt 2 und dem Fehlerort 8 genau berechnet und auf einer Anzeigeeinheit 16 ausgegeben werden.
Der Umfang der Rechenoperationen kann erheblich sein. Falls ein einfacher Mikroprozessor innerhalb einer vertretbaren Zeit kein befriedigendes Ergebnis liefert, kann man eine zusätzliche Datenschnittstelle vorsehen, die erst im Fehlerfall an einen Rechner mit höherer Rechenkapazität angeschlossen wird. Bei dieser Ausführungsform der Erfindung wird in der Meßstation lediglich der Datenspeicher 14 benötigt, während der Rechner in einer Zentrale untergebracht sein kann. Nach der Auswertung des Datensatzes im Speicher 14 wird dann das Ergebnis dem Servicepersonal vor Ort geliefert.

Die in Fig. 1 und 3 dargestellte Einrichtung zur Fehlerortung kann von einer Schaltstation aus mehrere sternförmig abgehende Kabelstränge überwachen, wenn man auf jedem Kabelstrang einen Stromsensor vorsieht und einen geeigneten Umschalter benutzt.
Von einer Schaltstation aus können aber auch mehrere in Reihe geschaltete Kabelabschnitte mit dazwischenliegenden Schaltstationen überwacht werden. Allerdings können dann Teilreflexionen in den Zwischenstationen Probleme bereiten.

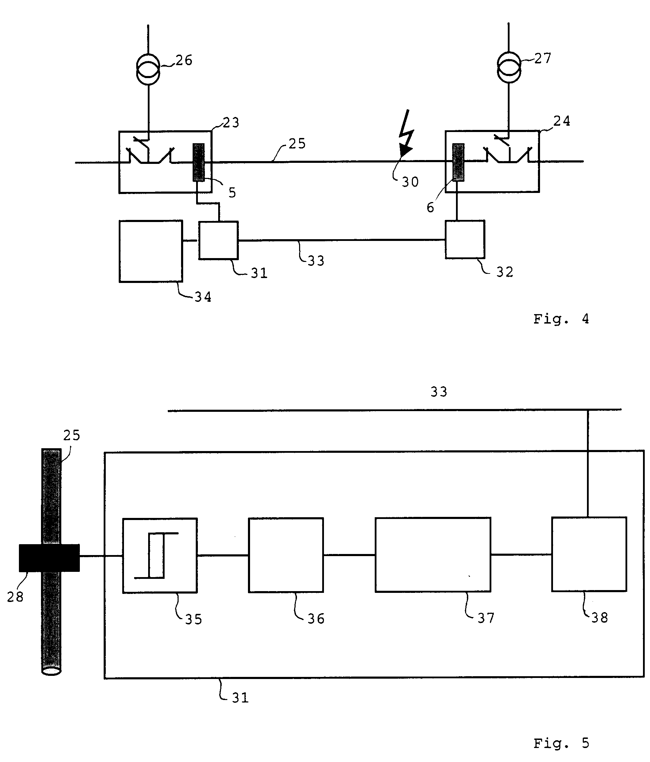

Bei einem weiteren Ausführungsbeispiel der Erfindung entsprechend Fig. 4 und 5 sind an beiden Enden des Kabels Sensoren vorgesehen.
Fig. 4 zeigt einen zwischen zwei Schaltstationen liegenden Kabelabschnitt,
Fig. 5 das dazugehörige Blockschaltbild.
In Fig. 4 ist zwischen zwei Schaltstationen 23 und 24 ein Kabel 225 verlegt. An diese Schaltstationen sind Transformatoren 26 und 27 angeschlossen. Am linken und rechten Ende des Kabels 25 sind in den Schaltstationen 23, 24 Kurzschlußsensoren 28, 29 angeordnet. Der Fehlerort ist mit 30 bezeichnet. Die Sensoren 28, 29 sind mit je einer Signalverarbeitungseinheit 31, 32 verbunden, die ihrerseits über eine Datenleitung 33 verknüpft sind. Eine zentrale Rechnereinheit 34 synchronisiert die Zeitbasen der Einheiten 31 und 32. In regelmäßigen Zeitabständen, vorzugsweise bei jedem Nulldurchgang der Netzspannung, sendet der Zentralrechner 34 ein Synchronisationssignal. Der absolute Gleichlauf der Uhren ist die Voraussetzung dafür, daß man die Laufzeiten des Kurzschlußsignals in der einen und anderen Richtung erfassen und daraus die Fehlerentfernung berechnen kann.
Um Referenzwerte für die Signallaufzeiten auf dem Energiekabel 25 und dem Signalkabel 33 zu erhalten, werden bei allen Schalthandlungen die Zeitpunkte des Eintreffens der Signalflanken gemessen und in der Zentraleinheit abgespeichert.
Beim Auftreten eines Kurzschlusses am Fehlerort 30 laufen die vom Lichtbogen erzeugten Signale auf dem Kabel 30 zu den Kurzschlußsensoren 28 und 29. Das Eintreffen dieser Signale an den Sensoren 28 und 29 wird mit Hilfe der Einheiten 31 und 32 exakt erfaßt.

In dem Blockschaltbild nach Fig. 5 ist dargestellt, wie die Signalverarbeitungseinheiten 31, 32 aufgebaut sind. Mit 25 ist das zu überwachende Kabel bezeichnet, das einen Kurzschlußsensor 28 trägt. Die mit dem Sensor verbundene Signalverarbeitungseinheit 31 besteht aus einem Trigger 35 für die Kurzschlußflanke, einem Speicher 36 für den Zeitpunkt des Signaleinganges, einer Zeitstufe 37 und einem Interface 38 für die Datenleitung.
Bei einen, Kurzschluß, der mit dem Kurzschlußsensor 28 und dem Trigger 35 erfaßt wird, hält der Speicher 36 in Verbindung mit der Zeitstufe 37 den exakten Zeitpunkt des Signaleinganges fest. Der Speicherinhalt wird anschließend über das Interface 38 und die Datenleitung 33 in den Zentralrechner 34 (Fig. 4) übertragen.
Entsprechende Abläufe finden in der Signalverarbeitungseinheit 32 am anderen Ende des Kabels 25 statt. Dem, Zentralrechner 34 stehen also zwei Datensätze zur Verfügung, aus denen die Signallaufzeitdifferenzen und die Abstände zum Fehlerort genau errechnet werden können.

Das in Fig. 4 und 5 beschriebene Ausführungsbeispiel der Erfindung kann dahingehend abgewandelt werden, daß die Datenkommunikation zwischen dem Zentralrechner und einer Vielzahl von Meß- und Schaltstationen drahtlos erfolgt.
In einer weiteren Variante der Erfindung ist an jedem Kabelende eine Signalverarbeitungseinheit vorgesehen, die einen Spannungssensor, einen Analog-Digital-Wandler, einen Trigger und einen Ringspeicher aufweist. Während des normalen Betriebes mißt der Spannungssensor ständig die aktuelle Spannung der Phase. Diese Meßwerte speisen den Analog-Digital-Wandler mit sehr hoher Umwandlungsrate. Die Digitalwerte werden in dem Ringspeicher mit so großer Kapazität abgelegt, daß etwa ein Datensatz für eine Vollwelle der Netzspannung Platz findet. Wenn zu irgendeinem Zeitpunkt eine steile Spannungsflanke den Trigger umschaltet, also ein Kurzschluß eingetreten ist, wird der Datennachschub gestoppt, so daß aus dem Signalverlauf vor und nach dem Kurzschluß die Gesamtlaufzeit auf dem Kabel bestimmt und daraus die Meßzeitpunkte an beiden Kabelenden synchronisiert werden können. Aus den unterschiedlichen Zeitpunkten des Eintreffens der Kurzschlußflanken an den Kabelenden läßt sich die Lage des Kurzschlusses bestimmen.
An die Stelle des erwähnten Spannungssensors kann dann ein Stromsensor treten wenn sichergestellt ist, daß in diesem Netz in jedem aktiven Betriebszustand ein mit einem Stromwandler meßbarer Mindeststrom fließt.
Wenn ein Ringkabelnetz überwacht werden soll, kann die erfindungsgemäße Anordnung in vereinfachter Form angewendet werden:
An der Einspeisung der beiden Stränge des Ringnetzes wird je ein Stromsensor angebracht.
Bei einem Kurzschluß an irgendeiner Stelle dieses Ringes laufen die Impulse in beide Richtungen los und treffen zu unterschiedlichen Zeiten in den Stromsensoren ein. Die Schaltung ist so beschaffen, daß der zuerst eintreffende Impuls eine Zeitstufe startet, der spätere, zweite Impuls über den anderen Sensor diese Zeitstufe stoppt. Aus der Laufzeitdifferenz zwischen beiden Impulsen und der bekannten Gesamtlänge der Ringleitung kann der Fehlerort berechnet werden.

Alle bisher angeführten Ausführungsbeispiele beruhen auf der Laufzeitmessung der elektrischen Impulse, die von dem Kurzschluß, einem Lichtbogen, direkt ausgelöst werden.
Man kann aber auch alternativ oder zusätzlich die Laufzeiten des Körperschalles erfassen, der von einem Lichtbogen ausgeht. Wenn an beiden Enden eines Kabels Schallsensoren angebracht sind, kann aus der Summe beider Laufzeiten und der bekannten Länge des Kabels die aktuelle Ausbreitungsgeschwindigkeit des Körperschalles berechnet werden.
Aus der Differenz der Laufzeiten wird dann der genaue Fehlerort bestimmt. Der Aufbau der Meßeinrichtungen ist den bereits beschriebenen sehr ähnlich.

Als Spannungs- oder Stromsensoren können ganz unterschiedliche Bauelemente eingesetzt werden. Außer mit den weitverbreiteten induktiven Strom- und Spannungswandlern kann man die vom Lichtbogen erzeugten Impulsflanken über einen frequenzkompensierten Spannungsteiler messen. Besonders vorteilhaft ist es, Stromwandler mit hoher Grenzfrequenz einzusetzen.
Auch ist es möglich, eine kapazitive Sonde auf einem nicht geschirmten Bereich der Kabelisolierung anzubringen. Als Sonderfall einer solchen Sonde ist es anzusehen, wenn man in der Anlage fest installierte, normgerechte kapazitive Meßpunkte benutzt.
Geeignet sind auch Stromsensoren in Form einer Rogowski-Spule oder eines Hallelementes.
Als Stromsensor kann auch ein magnetoresistiver Widerstand dienen.
Bei Erfassung des Körperschalls als Indiz für einen Lichtbogen ist ein piezokeramischer Schallwandler vorteilhaft.

### Gewerbliche Verwertbarkeit

Das neuartige Verfahren zur Lokalisierung von Kabelfehlern ist hervorragend geeignet, mit Hilfe von bekannten oder handelsüblichen Sensoren, Rechnern und Elektronikbausteinen Vorrichtungen gewerblich herzustellen, die den zu überwachenden Energiekabelnetzen optimal angepaßt sind.

### Bezugszeichenliste

- 1: Einspeisepunkt
- 2: Anfangspunkt
- 3: Endpunkt
- 4: Anschlußpunkt für Transformator
- 5, 6, 7: Schaltstationen
- 8: Fehlerort
- 9: Meßeinrichtung
- 10: überwachtes Kabel
- 11: Kabel
- 12: Stromsensor
- 13: Analog-Digital-Wandler
- 14: Datenspeicher
- 15: Mikroprozessor
- 16: Anzeigeeinheit
- 17, 18, 19: Impulse
- 20, 21, 22: Transformatoren
- 23, 24: Schaltstationen
- 25: Kabel
- 26, 27: Transformatoren
- 28, 29: Kurzschlußsensoren
- 30: Fehlerort
- 31, 32: Signalverarbeitungseinheiten
- 33: Datenleitung
- 34: Zentralrechner
- 35: Trigger für die Kurzschlußflanke
- 36: Speicher für den Zeitpunkt
- 37: Zeitstufe
- 38: Interface für die Datenleitung

## Patentansprüche

1. Verfahren zur Bestimmung des Abstandes eines Kabelfehlers vom Anfang eines Kabelabschnittes zur Fehlerstelle in Mittelspannungsnetzen der Energieversorgung,
dadurch gekennzeichnet,
daß die Laufzeiten der vom Lichtbogen erzeugten elektrischen und/oder akustischen Signale im Kabel in den Kabelabschnitten beiderseits vom Lichtbogen gemessen und daraus die Abstände der Fehlerstelle zu den Enden des Kabelabschnittes berechnet werden.

2. Verfahren zur Bestimmung des Abstandes eines Kabelfehlers vom Anfang eines Kabelabschnittes zur Fehlerstelle in Mittelspannungskabelnetzen der Energieversorgung nach Anspruch 1,
dadurch gekennzeichnet,
daß an beiden Enden eines Kabelabschnittes mit mindestens je einem Sensor zur Messung der vom Lichtbogen erzeugten elektrischen Impulse mit zeitlich miteinander synchronisierten Zeitstufen die exakten Zeitpunkte des Eintreffens der vom Lichtbogen erzeugten elektrischen Impulse bei Durchbruch des Lichtbogens gemessen werden, wobei die zeitliche Synchronisation der Zeitstufen an beiden Kabelenden durch Aufzeichnung des Signalverlaufes der Netzspannung und/oder des Netzstromes vor dem Kurzschluß und anschließender Korrelation beider Signalverläufe, durch Synchronisationsimpulse über eine Datenleitung oder mittels der Sychronisationsimpulse eines Zeitzeichensenders erfolgt und aus der Zeitdifferenz des Eintreffens der Impulse an beiden Kabelenden die Impulslaufzeiten und daraus der exakte Ort des Kabelfehlers bestimmt werden.

3. Verfahren zur Bestimmung des Abstandes eines Kabelfehlers vom Anfang eines Kabelabschnittes zur Fehlerstelle in Mittelspannungskabelnetzen der Energieversorgung in zu einem Ringnetz zusammengeschalteten Kabelnetzen nach Anspruch 1,
dadurch gekennzeichnet,
daß an beiden örtlich eng benachbarten Einspeisungsstellen eines Ringkabelnetzes Sensoren zur Überwachung des Phasenstromes vorhanden sind, mit denen der exakte Zeitpunkt des Eintreffens der vom Kurzschluß erzeugten Impulsflanken in den vom Kurzschluß geteilten Kabelabschnitten gemessen wird.

4. Verfahren zur Bestimmung des Abstandes eines Kabelfehlers vom Anfang eines Kabelabschnittes zur Fehlerstelle in Mittelspannungskabelnetzen der Energieversorgung nach Anspruch 1,
dadurch gekennzeichnet,
daß die Laufzeiten der Impulsflanke des vom Lichtbogen erzeugten Körperschalls an beiden Enden des Kabelabschnittes gemessen und daraus die exakte Lage des Kabelfehlers berechnet werden kann, wobei aus dem vom Lichtbogen erzeugten elektrischen Signal der Zeitpunkt des Lichtbogendurchbruchs bestimmt wird.

5. Verfahren zur Bestimmung des Abstandes eines Kabelfehlers vom Anfang eines Kabelabschnittes zur Fehlerstelle in Mittelspannungskabelnetzen der Energieversorgung nach Anspruch 1,
dadurch gekennzeichnet,
daß an einem Endpunkt des Kabelabschnittes mit mindestens einem Sensor die vom Lichtbogen erzeugten elektrischen Signale gemessen und in einem Speicher gespeichert werden, wobei die Laufzeiten der elektrischen Impulse direkt zur Meßstelle und nach Reflexionen an beiden Kabelenden durch eine Filterung und eine Korrelationsanalyse der gespeicherten Signale bestimmt werden und daraus der Abstand des Kabelfehlers vom Meßpunkt berechnet wird.

6. Vorrichtung zur Durchführung des Verfahrens nach Anspruch 2,
dadurch gekennzeichnet,
daß in Stationen (23, 224) am Anfang und Ende des überwachten Kabelabschnittes (25) Kurzschlußsensoren (28, 29) angeordnet sind, die Signalverarbeitungseinheiten (31, 32) speisen, die ihrerseits mit einem Rechner in Verbindung stehen, der die Abstände der Fehlerstelle (30) von den Sensoren (28, 29) ermittelt.

7. Vorrichtung nach Anspruch 6, dadurch gekennzeichnet,
daß die Signalverarbeitungseinheiten (31, 32) durch eine Datenleitung (33) mit einem Zentralrechner (34) verbunden sind.

8. Vorrichtung nach Anspruch 6, dadurch gekennzeichnet,
daß ein transportabler Rechner eingesetzt wird oder eine Funkverbindung zum Rechner besteht.

9. Vorrichtung nach Anspruch 6, dadurch gekennzeichnet. daß jede Signalverarbeitungseinheit (31, 32) aus einem Trigger (35) für die Kurzschlußflanke, einem Speicher (36) für den Zeitpunkt des Eintreffens, einer Zeitstufe (37) und einem Interface (38) für die Datenleitung (33) besteht.

10. Vorrichtung zur Ausübung des Verfahrens nach Anspruch 2, 3, 4 oder 5, dadurch gekennzeichnet, daß als Sensoren für die vom Lichtbogen erzeugten elektrischen Impulse Rahmen- oder Dipolantennen eingesetzt werden, die die hochfrequenten Anteile der Impulse erfassen.

11. Vorrichtung zur Ausübung des Verfahrens nach Anspruch 1, dadurch gekennzeichnet, daß am Anfangspunkt (2) eine Meßeinrichtung mit einem Kurzschlußsensor vorgesehen ist, der das von der Fehlerstelle (8) ausgehende elektrische Signal direkt erfaßt und zusätzlich das am Endpunkt (3) reflektierte Signal mißt wobei die Fehlerentfernung aus den Laufzeitdifferenzen errechnet wird.

12. Vorrichtung nach Anspruch 6, dadurch gekennzeichnet, daß für alle Phasen eines Netzes Kurzschlußsensoren vorgesehen sind, deren Signale in einer gemeinsamen Datenverarbeitungseinheit weiter verarbeitet werden.
